# EUROPÄISCHE PATENTSCHRIFT

(11) **EP 0 489 239 B1**
(45) Veröffentlichungstag und Bekanntmachung des Hinweises auf die Patenterteilung: **01.06.1994**
(21) Anmeldenummer: 91116695.7
(22) Anmeldetag: 30.09.1991
(51) Int. Cl.: C23C 14/34

(54) **Anordnung zum Beschichten von Substraten mit Magnetronkathoden**
Sputtering apparatus with magnetron cathodes for coating of substrates
Dispositif avec cathodes magnétron, pour le revêtement de substrates

(30) Priorität: 03.12.1990 DE 4038497
(43) Veröffentlichungstag der Anmeldung: 10.06.1992
(73) Patentinhaber: LEYBOLD AKTIENGESELLSCHAFT, D-63450 Hanau (DE)
(72) Erfinder: Hofmann, Dieter, Dipl.-Ing., W-6454 Bruchköbel (DE); Schüssler, Hans, W-6685 Schiffweiler (DE); Feuerstein, Albert, Dr. Phys., W-6451 Neuberg 2 (DE)

(56) Entgegenhaltungen:
- EP-A- 0 144 838
- US-A- 4 880 515
- US-A- 4 931 158
- PATENT ABSTRACTS OF JAPAN vol. 14, no. 77 (C-688)(4020) 14. Februar 1990
- PATENT ABSTRACTS OF JAPAN vol. 12, no. 344 (C-528)(3191) 16. September 1988
- JOURNAL OF VACUUM SCIENCE AND TECHNOLOGY Bd. 6, Nr. 6, 1. November 1988, WOODBURY, N.Y, U.S.A Seiten 3156 - 3158; G.Y. YEOM ET AL.: 'magnetic field designs for cylindrical post-magnetron discharge sourses'

## Beschreibung

Die Erfindung bezieht sich auf eine Anordnung zum Beschichten von Substraten, die innerhalb einer Vakuumkammer an einem Substrathalter angeordnet sind, der sich mindestens teilweise in einem Beschichtungsbereich befindet, auf dessen beiden Seiten Magnetronkatoden mit Magnetsystemen aus Permanentmagneten mit Außenpolen und Innenpolen angeordnet sind, deren Targets auf den Beschichtungsbereich ausgerichtet sind, wobei die Polung der Magnetsysteme der Magnetronkatoden so gewählt ist, daß sich jeweils Pole entgegengesetzter Polarität auf beiden Seiten des Beschichtungsbereichs gegenüberliegen.

Durch die DE-PS 31 07 914, die US-PS 4 871 434 und den Aufsatz von Münz, "Titanium aluminium nitride films: A New alternative to TiN coatings", J. Va. Sci. Technol. A4(6), Nov./Dez. 1986, Seiten 2717 bis 2725, ist es bekannt, Magnetronkatoden auch hinsichtlich der Polung der in ihnen enthaltenen Magnetsysteme spiegelsymmetrisch zu einem Transportweg für die Substrate anzuordnen, die durch den Zwischenraum zwischen den Targets hindurchbewegt werden. Die spiegelbildliche Anordnung gilt auch für die Ausbildung und die Pollage der Magnetsysteme. Mit einer solchen Anordnung gelingt es bei entsprechend schwacher Auslegung der Magnetsysteme und einer entsprechend hohen negativen Bias-Spannung an den Substraten bzw. am Substrathalter, das Plasma soweit auszudehnen, daß es die Substrate allseitig umspült. Üblicherweise dienen die Magnetsysteme von Magnetronkatoden dazu, das Plasma sehr weitgehend in der Nähe der Targetoberfläche zu halten, um dadurch die Zerstäubungsrate gegenüber sogenannten Dioden-Anordnungen um den Faktor 10 bis 30 zu erhöhen und gleichzeitig den Energiefluß zu den Substraten zu reduzieren. Die angegebene Schwächung der Magnetsysteme und die Anwendung einer negativen Bias-Spannung dienen also gewissermaßen in Zusammenwirkung dazu, die konzentrierende Wirkung des magnetischen Tunnels teilweise aufzuheben, um die Substrate unmittelbar dem Plasma auszusetzen.

Der vorstehend beschriebene Kunstgriff funktioniert jedoch nur solange, wie die Substrate keine all zu große Abmessungen haben, bzw. solange, wie ein Substrathalter, auf dem sich mehrere Substrate befinden, keine all zu großen Querabmessungen aufweist. Die besagten Abmessungen bestimmen nämlich den minimalen Abstand der Targets voneinander.

Die JA-OS 1-83 659 offenbart keine Magnetronkatoden und auch keine magnetische Falle für den Einschluß des Plasmas. Es handelt sich vielmehr um eine Dioden-Anordnung mit überlagertem Magnetfeld, das jedoch nur zur Orientierung der Kristalle während der Schichtbildung dient. Bei den Magnetsystemen handelt es sich um unipolare Systeme, d.h. es fehlt der für weitgehend ebene Magnetronkatoden unerläßliche Mittenpol, und die Randzone bildet einen einzigen Pol, nämlich entweder "N" oder "S". Die Schließung des magnetischen Kreises erfolgt außerhalb der Vakuumkammer.

Die US-PS 4 880 515 offenbart eine Doppelanordnung von Magnetronkatoden der eingangs genannten Gattung, bei der die Polung der Magnetsysteme so gewählt ist, daß sich jeweils Pole entgegengesetzter Polarität auf beiden Seiten des Beschichtungsbereichs gegenüberliegen. Dabei soll der Abstand der beiden Magnetronkatoden möglichst gering gehalten werden, um einen guten Wirkungsgrad bei hoher Niederschlagsmenge pro Zeiteinheit und guter Ausnutzung des Targetmaterials zu erzielen, und das Substrat soll außerhalb des Plasmabereichs angeordnet werden, so daß der niedergeschlagene Film nicht mehr durch das Plasma geätzt wird. Insbesondere aber soll die Wirkung der Magnetronkatoden so verstärkt werden, daß ein dichter Plasmabereich nur in der Nähe der Targetoberfläche erzeugt wird, so daß das Substrat in kurzem Abstand vor dem Target angeordnet werden kann, und sich selbst dann noch außerhalb des Plasmabereichs befindet.

Es sind in der Vergangenheit zahlreiche Arbeiten über elektromagnetisch verstimmte Magnetronkatoden bekannt geworden, die auch als "unbalanced magnetrons" bezeichnet werden. Durch eine entsprechende Feldüberlagerung von Permanent- und Elektromagneten wird erreicht, daß die magnetischen Feldlinien sehr viel weiter in den Raum vor der Zerstäubungsfläche des Targets hinein erstrecken, so daß sich auch der plasmaerfüllte Raum entsprechend ausdehnt. Diese räumliche Ausdehnung des Plasmas wird dann dazu benutzt, um entsprechend groß dimensionierte Substrate oder Substratanordnungen bzw. Substratgruppen im Plasma unterzubringen. Das Plasma wirkt aber auch hierbei nur einseitig, d.h. von der einen Magnetronkatode her auf die Substrate ein.

Der Erfindung liegt daher die Aufgabe zugrunde, eine Anordnung der eingangs beschriebenen Gattung anzugeben, mit der ein Beschichtungsbereich großen Volumens erzeugt werden kann, durch den eine Vielzahl von Substraten entweder hindurchtransportiert werden kann, oder in dem sich gleichzeitig eine Vielzahl von Substraten aufhalten kann. Anstelle der Vielzahl von Substraten kann natürlich auch ein entsprechend großvolumiges Substrat in dem Beschichtungsbereich untergebracht werden. Vereinfacht ausgedrückt soll der lichte Abstand der Targets erheblich vergrößert werden, ohne daß die Magnetfeldstärke auch an der ungünstigsten Stelle unter den für den Plasmaeinschluß notwendigen kritischen Grenzwert absinkt.

Die Lösung der gestellten Aufgabe erfolgt bei der eingangs angegebenen Anordnung erfindungsgemäß dadurch, daß
a) auf gegenüberliegenden Seiten des Beschichtungsbereichs jeweils mindestens eine Magnetspule angeordnet ist, wobei die gegenüberliegenden Magnetspulen jeweils einer Magnetronkatode zugeordnet und in der Weise an eine Stromversorgung angeschlossen sind, daß sich die Felder der Magnetspulen zu einem geschlossenen Magnetfeld ergänzen, in dem sich der Beschichtungsbereich befindet, und daß
b) die Pollage der Außenpole der Permanentmagnetsysteme und der Magnetspulen gleichsinnig ist.

Durch die erfindungsgemäßen Maßnahmen wird erreicht, daß sich von einer Magnetronkatode zu der gegenüberliegenden anderen Magnetronkatode eine Art "ununterbrochener magnetischer Schlauch" erstreckt, der gleichzeitig den Beschichtungsbereich umschließt. In diesem magnetischen Schlauch befindet sich ein Plasma hoher Intensität, das sich durch eine hohe Konzentration von Elektronen auszeichnet, die schraubenlinienförmige Bewegungen um die Magnetfeldlinien ausführen. Hierdurch wird auch die Ionisationswahrscheinlichkeit ganz erheblich erhöht.

Von Bedeutung ist dabei die Polung der Magnetspulen untereinander, insbesondere aber in Verbindung mit der Polung der Magnetsysteme der Magnetronkatoden. Diese Polung ist im Hinblick auf eine zwischen den Targets liegende Symmetrieebene nicht spiegelsymmetrisch, und zwar liegen auf beiden Seiten dieser virtuellen Symmetrieebene jeweils Pole unterschiedlicher Polarität.

Von Bedeutung ist dabei auch, daß die Magnetronkatoden Magnetsysteme besitzen, wie sie für solche Magnetronkatoden an sich üblich sind, d.h. einem Außenpol, der einen geschlossen Verlauf in Form eines Kreisrings, eines Rechtecks oder eines Ovals ("Rennbahn") aufweist, ist ein Innenpol zugeordnet, der die Form einer Kreisfläche oder einer langgestreckten Leiste aufweisen kann, so daß sich zwischen Außenpol und Innenpol ein in sich geschlossener magnetischer Tunnel ausbilden kann.

Einzelheiten dieser Maßnahmen und ihre Auswirkungen werden in der Detailbeschreibung noch näher erläutert.

Es ist dabei besonders vorteilhaft, wenn mindestens beiderseits einer virtuellen Hüllfläche, die sich zwischen den Rändern der gegenüberliegenden Targets erstreckt und die den Beschichtungsbereich umgibt, mindestens je eine Elektrode angeordnet ist, die von der Vakuumkammer isoliert und an eine gegenüber Masse positive Spannung legbar ist, vorzugsweise auf eine Spannung zwischen +10 und +220 V.

Es ist dabei weiterhin von Vorteil, wenn auf der dem Beschichtungsbereich abgekehrten Außenseite der vorstehend beschriebenen mindestens einen Elektrode mindestens ein weiteres Magnetsystem mit Außen- und Innenpolen angeordnet ist, das auf der dem Beschichtungsbereich zugekehrten Innenseite der Elektrode mindestens einen geschlossenen magnetischen Tunnel bildet, und wenn die Polung der Außenpole der Magnetsysteme der Elektroden entgegengesetzt zur Polung der Außenpole der Magnetsysteme der jeweils benachbarten Magnetronkatoden gewählt ist.

Durch diese Maßnahme erfolgt - durch Magnetfeldüberlagerung - eine Aufweitung des "magnetischen Schlauches" in Richtung auf die genannte mindestens eine Elektrode. Dies führt wiederum zu einer Vergrößerung des plasmaerfüllten Volumens, so daß in dem Plasma entsprechend größere Substrate bzw. Gruppen von Substraten untergebracht werden können.

Es ist dabei weiterhin von Vorteil, wenn bei Verwendung von Magnetronkatoden mit rechteckigem Targetumriß und bei Verwendung von zwei einander gegenüberliegenden zusätzlichen Elektroden mit gleichfalls rechteckigem Umriß die Längskanten der Magnetronkatoden und der zusätzlichen Elektroden etwa gleich lang und parallel zueinander angeordnet sind.

Weitere vorteilhafte Ausgestaltungen des Erfindungsgegenstandes ergeben sich aus den übrigen Unteransprüchen sowie aus der Detailbeschreibung.

Ausführungsbeispiele des Erfindungsgegenstandes werden nachfolgend anhand der Figuren 1 bis 5 näher erläutert.

Es zeigen - jeweils in schematischer Darstellung:
- Figur 1: einen Axialschnitt durch eine Anordnung zweier gegenüberliegender Magnetron-Katoden, die in die zueinander parallelen Stirnseiten einer Vakuumkammer eingesetzt sind und bei denen die Magnetspulen außen liegend angeordnet sind,
- Figur 2: eine Anordnung analog Figur 1, bei der sich jedoch die Magnetronkatoden und Magnetspulen im Innern der Vakuumkammer befinden,
- Figur 3: eine Anordnung von zwei Magnetronkatoden mit Magnetspulen analog Figur 1, jedoch mit zwei zusätzlichen Elektroden, hinter denen weitere Magnetsysteme angeordnet sind,
- Figur 4: eine Anordnung analog Figur 3, jedoch mit dem Unterschied, daß die Magnetronkatoden und die ihnen zugeordneten Magnetspulen im Innern der Vakuumkammer angeordnet sind, und
- Figur 5: eine Anordnung analog Figur 2, bei der jedoch innerhalb jeweils einer Magnetspule jeweils zwei Magnetronkatoden in enger Nachbarschaft zueinander angeordnet sind.

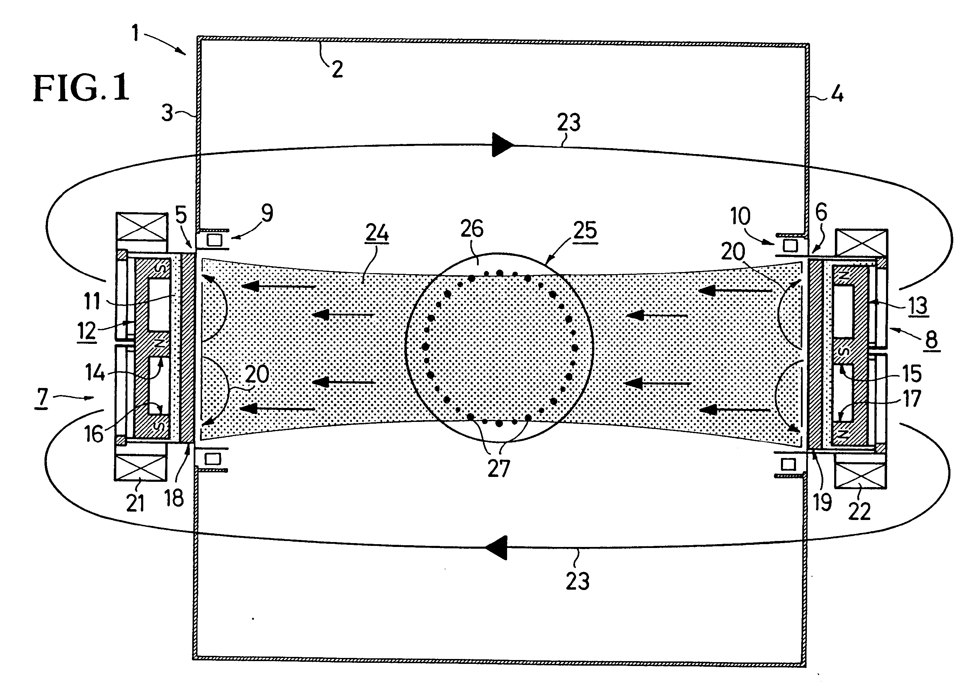

In Figur 1 ist eine Vakuumkammer 1 dargestellt, die eine beliebige Form haben kann. So kann die Mantelwand 2 einen quaderförmigen oder zylindrischen Raum umschließen, wobei in dem zuletzt genannten Fall die Kammerachse waagrecht verläuft. Die Kammerwand besitzt an den beiden gegenüberliegenden Enden zwei zueinander parallele Stirnwände 3 und 4, in denen sich Öffnungen 5 und 6 für das Einsetzen je einer Magnetronkatode 7 und 8 befinden.

Die zu Vakuumpumpen und Gasquellen führenden Rohrleitungen sind der Einfachheit halber nicht dargestellt. Es ist lediglich jeweils eine Gasverteilerleitung 9 bzw. 10 gezeigt, die die jeweilige Öffnung 5 bzw. 6 umgibt und eine Vielzahl von Austrittsöffnungen besitzt, durch die ein Gas oder Gasgemisch in die Vakuumkammer 1 eingeleitet werden kann. Bei den Gasen kann es sich um Edelgase wie beispielsweise Argon handeln. Sofern reaktive Verfahren durchgeführt werden sollen, können zusätzlich oder allein reaktive Gase wie Sauerstoff oder Stickstoff über die Gasverteilerleitungen 9 und 10 zugeführt werden. Sofern als Schichten Karbide oder Polymerisate niedergeschlagen werden sollen, können über die Gasverteilerleitungen 9 und 10 entsprechende geeignete Kohlenwasserstoffe zugeführt werden, erforderlichenfalls auch im Gemisch mit einem Edelgas. Die Regelsysteme für die Gasversorgung sind ebensowenig dargestellt wie die Stromversorgungen und Regeleinrichtungen für die Magnetronkatoden 7 und 8.

Bei den Magnetronkatoden 7 und 8 handelt es sich um solche herkömmlicher Bauart: In einem als hohle Kupferwanne ausgebildeten Katodengrundkörper 11 ist hinter dem Wannenboden jeweils ein Magnetsystem 12 bzw. 13 angeordnet. Jedes dieser Magnetsysteme besteht aus einem Innenpol 14 bzw. 15 und einem Außenpol 16 bzw. 17. Die Innenpole 14 bzw. 15 können nun kreisförmige Polflächen besitzen. Die Außenpole bestehen in der Regel aus einer endlosen bzw. geschlossenen Reihe von Einzelmagneten, deren gleichnamige Polflächen in einer Kreisringfläche liegen können. In diesem Falle handelt es sich um rotationssymmetrische Magnetronkatoden. Es ist aber auch und mit besonderem Vorteil möglich, die Innenpole langgestreckt (mit schmaler rechteckiger Polfläche) und die Außenpole auf dem Umfang eines Rechtecks oder Ovals anzuordnen, so daß sogenannte "Rechteckkatoden" gebildet werden.

Auf der den Magnetsystemen gegenüberliegenden Seite des Bodens eines jeden Katodengrundkörpers 11 befindet sich jeweils ein plattenförmiges Target 18 bzw. 19, dessen Umriß dem Verlauf der Außenpole 16 bzw. 17 entspricht. Durch die Wirkung der Magnetsysteme 12 und 13 wird auf der äußeren Oberfläche der Targets 18 und 19, der sogenannten Zerstäubungsfläche, ein endloser magnetischer Tunnel gebildet, der durch die bogenförmig gekrümmten magnetischen Feldlinien 20 angedeutet ist. Diese Feldlinien definieren ein sogenanntes "Nahfeld", und im Normalfalle wäre die Ausbildung einer intensiven Plasmaentladung auf das von den Feldlinien 20 umschlossene Volumen beschränkt.

Zwischen den Magnetronkatoden 7 und 8 befindet sich nun der sogenannte "Beschichtungsbereich", auf den nachfolgend noch näher eingegangen wird. Bei der dargestellten Anordnung ist jedoch bereits ein vom Stande der Technik verschiedenes Merkmal vorhanden: Die Polung der Magnetsysteme 12 und 13 ist nämlich so gewählt, daß sich auf gegenüberliegenden Seiten des Beschichtungsbereichs jeweils Pole entgegengesetzter Polarität gegenüberliegen. So ist beispielsweise der Außenpol 16 des Magnetsystems 12 in Richtung auf das Target 18 als Südpol ausgebildet, während der Außenpol 17 des Magnetsystems 13 in Richtung auf das Target 19 als Nordpol ausgebildet ist. Die Innenpole 14 und 15 haben naturgemäß jeweils eine entgegengesetzte Polarität.

Die Magnetronkatoden 7 und 8 bzw. deren Katodengrundkörper 11 sind auf dem Außenumfang von je einer Magnetspule 21 bzw. 22 umgeben, und zwar mit relativ geringem Abstand. Die Stromquellen für diese Magnetspulen sind der Einfachheit halber nicht dargestellt. Der Wickelsinn und die Anschlüsse der beiden Magnetspulen 21 und 22 sind dabei jedoch so gewählt, daß sich an den beiden Magnetspulen nicht einzelne, in sich geschlossene, Magnetfelder ausbilden, sondern so, daß sich die Felder der beiden Magnetspulen zu einem geschlossenen Magnetfeld ergänzen, das beide Magnetspulen einschließt. Der Verlauf dieses Magnetfeldes wird durch die Linien 23 symbolisiert.

Durch die gewählte Pollage sowohl der Magnetsysteme 12 und 13 als auch der Magnetspulen 21 und 22 wird nun eine Art "magnetischer Schlauch" geschaffen, der praktisch ein Volumen ausfüllt, das in einer virtuellen Hüllfläche liegt, die durch Mantellinien gebildet wird, die sich geradlinig zwischen den einander gegenüberliegenden Rändern der Targets erstrecken. Der dadurch gebildete Plasmabereich, auch "Beschichtungsbereich" genannt, ist in den Figuren schattiert dargestellt. Bei rotationssymmetrischen Magnetronkatoden, d.h. bei solchen mit kreisscheibenförmigen Targets, hat dieser Bereich in etwa die Form eines Zylinders. Bei sogenannten Rechteckkatoden hat der Beschichtungsbereich die Form eines Quaders. Bei Rechteckkatoden würde sich die längste Achse senkrecht zur Zeichenebene gemäß Figur 1 erstrecken, und die Tiefenausdehnung des Beschichtungsbereichs 24 wäre entsprechend.

In der Mitte des Beschichtungsbereichs befindet sich ein drehbarer Substrathalter 25, dessen angetriebene Drehachse gleichfalls senkrecht zur Zeichenebene in Figur 1 verläuft. Zu diesem Substrathalter gehört eine kreisscheibenförmige Grundplatte 26, an der in zur Drehachse konzentrischer Anordnung eine Vielzahl von Haltestäben 27 befestigt ist, die zur Aufnahme einzelner Substrate dienen. Ein derartiger Substrathalter wird auch als "Käfig" bezeichnet. Durch die vergrößerte räumliche Ausbildung des Beschichtungsbereichs 24, der durch das sogenannte magnetische "Fernfeld" begrenzt wird, ist es jedenfalls möglich, entweder ein großes Einzelsubstrat oder eine Vielzahl von kleineren Substraten in einer beträchtlich vergrößerten Beschichtungszone unterzubringen. In dieser Beschichtungszone werden die Substrate durch das Plasma von beiden Seiten her, d.h. aus der Richtung der beiden Magnetronkatoden 7 und 8, beaufschlagt. Durch die Rotation des Substrathalters 25 werden die Substrate nacheinander allseitig dem Plasma ausgesetzt, und dieser Effekt kann noch dadurch verbessert werden, daß auch die einzelnen Haltestäbe um ihre eigenen Achsen gedreht werden, so daß die Substrate Bewegungen nach Art einer Zykloide oder Evolvente ausführen.

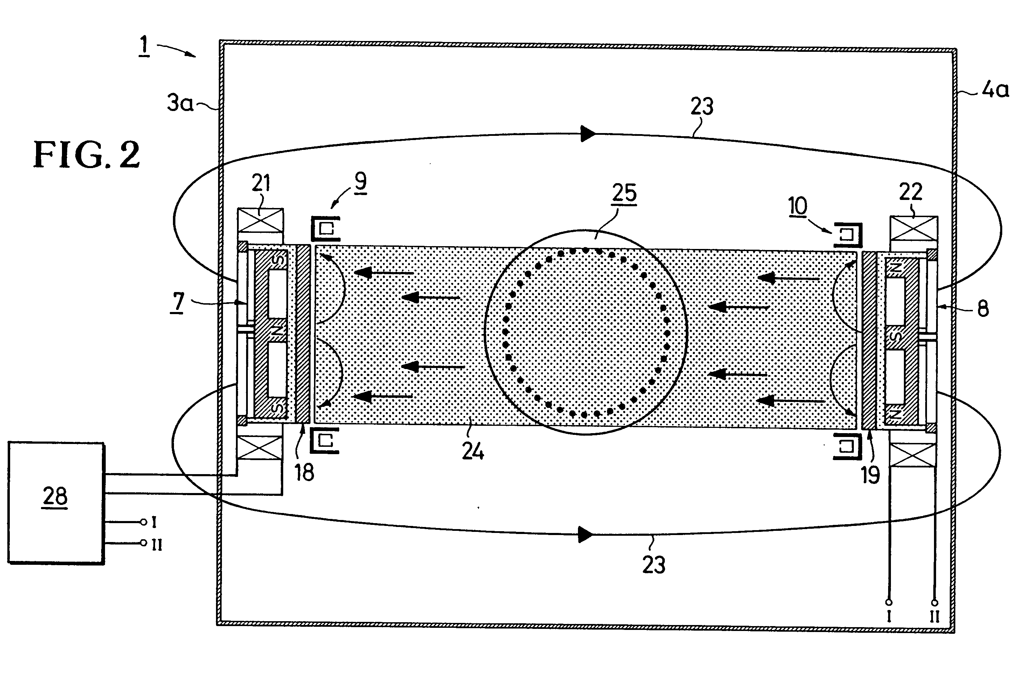

Es bleibt noch zu erwähnen, daß im vorliegenden Fall die Vakuumkammer 1 aus einem amagnetischen Werkstoff wie Edelstahl besteht, so daß die rückgeführten magnetischen Feldlinien entsprechend den Linien 23 durch die Stirnwände 3 und 4 hindurch verlaufen können.
Eine weitgehend analoge Anordnung zeigt Figur 2, jedoch mit dem Unterschied, daß die Vakuumkammer 1 zwei geschlossene Stirnwände 3a und 4a besitzt und daß die Magnetronkatoden 7 und 8 sowie die Magnetspulen 21 und 22 im Innern der Vakuumkammer, aber in unmittelbarer Nachbarschaft der Stirnwände 3a und 4a angeordnet sind. Dargestellt ist noch eine Stromquelle 28 für die Versorgung der Magnetspulen 21 und 22 mit dem erforderlichen Erregerstrom (Gleichstrom).

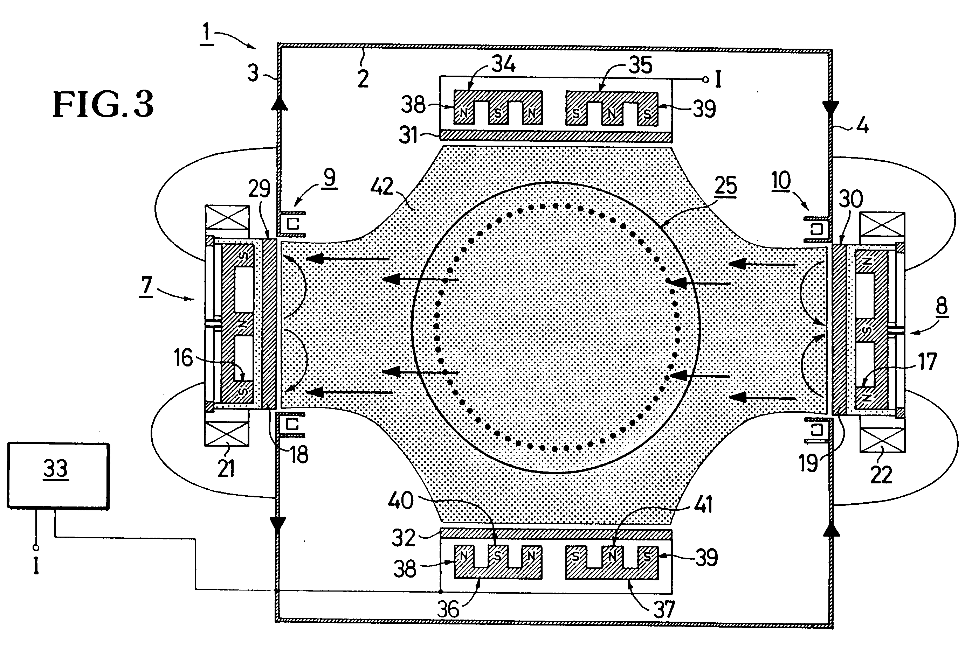

Figur 3 zeigt eine Anordnung analog Figur 1 jedoch mit dem ersten Unterschied, daß die Vakuumkammer 1 in diesem Fall aus einem ferromagnetischen Werkstoff besteht, so daß die Rückführung des magnetischen Flusses entsprechend den eingezeichneten Pfeilen über die Vakuumkammer 1 erfolgt. Hinsichtlich der räumlichen Pollagen der Magnetsysteme der Magnetronkatoden 7 und 8 und der Magnetspulen 21 und 22 gilt das gleiche wie für die Gegenstände nach den Figuren 1 und 2. In diesem Falle sind jedoch beiderseits einer virtuellen Hüllfläche, die sich zwischen den Rändern 29 und 30 der gegenüberliegenden Targets 18 und 19 erstreckt, und die im wesentlichen einen Beschichtungsbereich umgibt, wie er in den Figuren 1 und 2 dargestellt ist, zwei plattenförmige Elektroden 31 und 32 angeordnet, die - ebenso wie die Magnetronkatoden 7 und 8 - gegenüber der Vakuumkammer 1 isoliert befestigt sind. Im Betrieb haben diese Elektroden 31 und 32 Anodenfunktion, d.h. sie können mittels einer Spannungsquelle 33 auf ein entsprechendes positives Potential gelegt werden.

Vom Substrathalter 25 aus gesehen, befinden sich jenseits der Elektroden 31 und 32, jedoch im Schatten dieser Elektroden je zwei weitere Magnetsysteme 34, 35 bzw. 36, 37, die gleichfalls Außenpole 38 bzw. 39 und Innenpole 40 bzw. 41 besitzen. Die Pollage der Magnetsysteme 34 bis 37 ist dabei absolut abwechselnd, und zwar auch bezüglich der jeweils unmittelbar benachbarten Magnetsysteme 34/35 und 36/37, so daß sich zwischen sämtlichen Polen bogenförmige Magnetfeldlinien ausbilden. Dabei bilden allerdings nur die Feldlinien jeweils eines Magnetsystems über der jeweils zugehörigen Teilfläche der Elektrode 31 bzw. 32 einen in sich geschlossenen magnetischen Tunnel.

Es ist dabei weiterhin von Bedeutung, daß die Außenpole 38 und 39 der jeweils paarweise angeordneten Magnetsysteme 34/35 und 36/37 eine gegenüber den nächstliegenden Außenpolen 16 bzw. 17 der Magnetsysteme 12 bzw. 13 der jeweils benachbarten Magnetronkatoden 7 bzw. 8 eine wiederum entgegengesetzte Polung aufweisen. Schreitet man in Gedanken sämtliche Magnetpole auf dem Umfang ihrer in sich praktisch geschlossenen Reihenanordnung ab, so durchwandert man sämtliche Pole ausschließlich in der Reihenfolge N-S-N-S-N-S .... Dies führt dazu, daß das Plasma auf seiner gesamten Oberfläche zwischen Elektroden und Feldlinien eingeschlossen ist. Wie sich insbesondere aus Figur 3 ergibt, wird dadurch ein nochmals deutlich vergrößerter Beschichtungsbereich 42 gebildet.

Dadurch wird der Beschichtungsbereich 42 im Bereich der Elektroden 31 und 32 in Richtung auf diese volumensmäßig auseinandergezogen, so daß der in Figur 3 dargestellte Substrathalter 25 einen wesentlich größeren Druchmesser haben kann als die Substrathalter in den Figuren 1 und 2.

Es versteht sich, daß die Elektroden 31 und 32 auch aus einem zerstäubungsfähigen Werkstoff bestehen können, so daß durch den Anschluß dieser Elektroden an eine entsprechend hohe negative Spannung weitere Magnetronkatoden gebildet werden, so daß in diesem Falle der Substrathalter 25 auf dem Umfang von insgesamt sechs Magnetronkatoden umgeben ist, was die Durchsatzleistung der Vorrichtung entsprechend erhöht. Dies führt im Ergebnis dazu, daß beiderseits einer virtuellen Hüllfläche, die sich zwischen den je ein Rechteck bildenden Rändern der gegenüberliegenden Targets 18 und 19 erstreckt, vier weitere Magnetronkatoden mit Targets gebildet werden, die durch die Magnetsysteme 34, 35, 36 und 37 definiert sind.

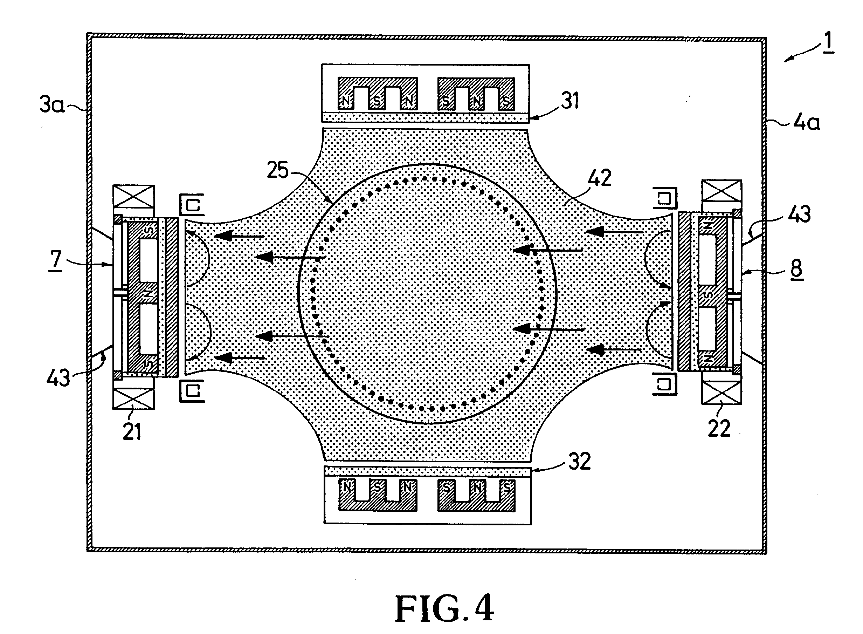

Figur 4 unterscheidet sich im wesentlichen dadurch von Figur 3, daß in diesem Falle wiederum die Magnetronkatoden 7 und 8 sowie die Magnetspulen 21 und 22 im Innern der Vakuumkammer 1 angeordnet sind. Auch in diesem Falle besteht die Vakuumkammer aus ferromagnetischem Werkstoff, so daß die Kammerwände als magnetischer Rückschluß dienen können, was durch die Teilabschnitte 43 der magnetischen Feldlinien angedeutet wird.

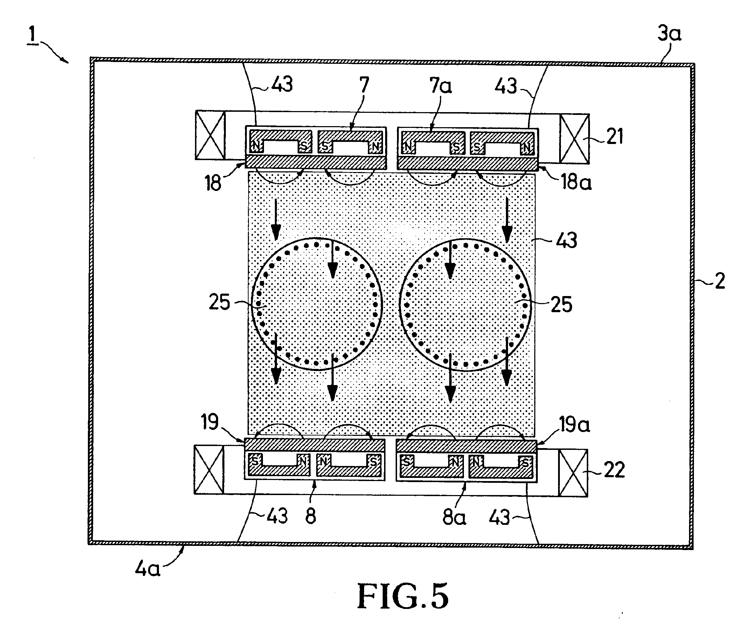

Bei dem Ausführungsbeispiel nach Figur 5 liegt ein Konstruktionsprinzip einer Vorrichtung vor, bei dem auf jeder Seite der Vakuumkammer 1 Magnetronkatoden 7/8 und 7a/8a paarweise einander gegenüberliegend angeordnet sind, und auf jeder Seite der Vakuumkammer im Bereich von deren Stirnwand 3a bzw. 4a eine Katodengruppe 7/7a bzw. 8/8a bilden, bei der die Abstände der Längskanten (senkrecht zur Zeichenebene) unmittelbar benachbarter Targets 18/18a bzw. 19/19a klein sind im Verhältnis zu den Abständen der Längskanten des gleichen Targets (gleichfalls senkrecht zur Zeichenebene), und daß im Bereich der Peripherie einer jeden Katodengruppe 7/7a bzw. 8/8a je eine Magnetspule 21 bzw. 22 angeordnet ist.

Auch durch dieses Konstruktionsprinzip wird ein besonders großer Beschichtungsbereich 43 erzielt, in dem in diesem Falle sogar zwei Substrathalter 25 angeordnet werden können.

Mit den bevorzugten Anordnungen nach den Figuren 3 und 4 lassen sich folgende Verfahren durchführen:

### Ätzen:

Zur Vermeidung einer Verunreinigung durch die Substrate durch Beschichtung beim Ätzprozeß wird an die Magnetronkatoden 7, 8ein relativ geringes Potential angelegt, das zwischen -100 und -300 V liegen kann. An dem Substrathalter wird eine Spannung zwischen -300 und -2000 V gewählt. Der Ätzvorgang erfolgt in reinem Argon bei Drücken zwischen 5 x 10⁻⁴ bis 5 x 10⁻² mbar. Beim Ätzen werden in Abhängigkeit von der Plasmadichte, die durch Einstellungen der Katoden, Anoden und des Drucks bestimmt wird, Stromdichten zwischen 1 und 4 mA/cm² erreicht. Durch das Vorliegen des allseitigen Plasmaeinschlusses wird eine gleichmäßige und intensive Ätzung ermöglicht. Es hat sich als möglich erwiesen, auch geometrisch komplizierte Teile und große Gruppen von Teilen erfolgreich zu ätzen. Auch hat sich gezeigt, daß temperaturempfindliche Teile ohne Überhitzung geätzt werden können.

### Beschichten:

Hier können bei einer Zerstäubungsspannung zwischen -500 und -800 V an den Magnetronkatoden in reaktiver Atmosphäre, ausgehend von entsprechenden metallischen Targets, bevorzugt Teile bzw. Substrate mit Hartstoffschichten versehen werden, beispielsweise mit TiAl-NxCy, TiN, TiNC, TiC, CrNx, ME:C. Dies geschieht bei niedrigen Substrattemperaturen und dennoch gleichmäßigem Ionenbeschuß der Substrate bei einer hohen Substratstromdichte die größer ist als 1 mA/cm². Um bei Schneidwerkzeugen die Schneidkanten zu schonen, wird bevorzugt ein niedriges Substratpotential verwendet, das nicht stärker negativ ist als etwa 150 V.

Das Bauprinzip ist sowohl für Durchlaufanlagen als auch für chargenweise betreibbare Anlagen geeignet. Bei Durchlaufanlagen kann man sich vorstellen, daß die Substrathalter 25 durch den Zwischenraum zwischen den Magnetronkatoden hindurchbewegt werden.

## Patentansprüche

1. Anordnung zum Beschichten von Substraten, die innerhalb einer Vakuumkammer (1) an einem Substrathalter (25) angeordnet sind, der sich mindestens teilweise in einem Beschichtungsbereich (24, 42, 43) befindet, auf dessen beiden Seiten Magnetronkatoden (7, 8) mit Magnetsystemen (12, 13) aus Permanentmagneten mit Außenpolen (16, 17) und Innenpolen (14, 15) angeordnet sind, deren Targets (18, 19) auf den Beschichtungsbereich (24, 42, 43) ausgerichtet sind, wobei die Polung der Magnetsysteme (12, 13) der Magnetronkatoden (7, 8) so gewählt ist, daß sich jeweils Pole entgegengesetzter Polarität auf beiden Seiten des Beschichtungsbereichs (24, 42, 43) gegenüberliegen, **dadurch gekennzeichnet,** daß
a) auf gegenüberliegenden Seiten des Beschichtungsbereichs (24, 42, 43) jeweils mindestens eine Magnetspule (21, 22) angeordnet ist, wobei die gegenüberliegenden Magnetspulen (21, 22) in der Weise an eine Stromquelle (28) angeschlossen sind, daß sich die Felder der Magnetspulen (21, 22) zu einem geschlossenen Magnetfeld ergänzen, und daß
b) die Pollage der Außenpole (16, 17) der Permanentmagnetsysteme (12, 13) und der Magnetspulen (21, 22) gleichsinnig ist.

2. Anordnung nach Anspruch 1, **dadurch gekennzeichnet,** daß mindestens beiderseits einer virtuellen Hüllfläche, die sich zwischen den Rändern (29, 30) der gegenüberliegenden Targets (18, 19) erstreckt und die den Beschichtungsbereich (24, 43) umgibt, mindestens eine Elektrode (31, 32) angeordnet ist, die von der Vakuumkammer (1) isoliert und an eine gegenüber Masse positive Spannung legbar ist.

3. Anordnung nach Anspruch 2, **dadurch gekennzeichnet,** daß auf der dem Beschichtungsbereich (42) abgekehrten Außenseite der Elektrode (31, 32) mindestens ein weiteres Magnetsystem (34, 35, 36, 37) mit Außen- (38, 39) und Innenpolen (40, 41) angeordnet ist, das auf der dem Beschichtungsbereich (42) zugekehrten Innenseite der Elektrode (31, 32) mindestens einen geschlossenen magnetischen Tunnel bildet, und daß die Polung der Außenpole (38, 39) der Magnetsysteme der Elektroden entgegengesetzt zur Polung der Außenpole (16, 17) der Magnetsysteme (12, 13) der jeweils benachbarten Magnetronkatoden (7, 8) gewählt ist.

4. Anordnung nach Anspruch 2, **dadurch gekennzeichnet,** daß bei Verwendung von Magnetronkatoden (7, 8) mit rechteckigem Targetumriß und bei Verwendung von zwei einander gegenüberliegenden Elektroden (31, 32) mit rechteckigem Umriß die Längskanten etwa gleich lang und parallel zueinander angeordnet sind.

5. Anordnung nach Anspruch 4, **dadurch gekennzeichnet,** daß auf den Außenseiten der beiden gegenüberliegenden Elektroden (31, 32) mindestens je ein langgestrecktes Magnetsystem (34, 35, 30, 37) für die Erzeugung mindestens eines geschlossenen magnetischen Tunnels auf jeder Innenfläche der jeweiligen Elektrode (31, 32) angeordnet ist.

6. Anordnung nach Anspruch 4, **dadurch gekennzeichnet,** daß auf jeder Seite der Vakuumkammer (1) mehrere Magnetronkatoden (7, 8; 7a, 8a) paarweise einander gegenüberliegend angeordnet sind, die auf jeder Seite der Vakuumkammer (1) eine Katodengruppe bilden, bei der die Abstände der Längskanten unmittelbar benachbarter Targets (18/18a; 19/19a) klein sind im Verhältnis zu den Abständen der Längskanten des gleichen Targets, und daß im Bereich der Peripherie einer jeden Katodengruppe je eine Magnetspule (21, 22) angeordnet ist.

7. Anordnung nach Anspruch 1, **dadurch gekennzeichnet,** daß beiderseits einer virtuellen Hüllfläche, die sich zwischen den je ein Rechteck bildenden Rändern der gegenüberliegenden Targets (18, 19) erstreckt, zwei weitere Magnetronkatoden mit Targets angeordnet sind.

8. Anordnung nach Anspruch 1, **dadurch gekennzeichnet,** daß bei Verwendung einer Vakuumkammer (1) aus ferromagnetischem Werkstoff die Magnetspulen (21, 22) den Kammerwänden (3a, 4a) derart angenähert sind, daß die Kammerwände einen magnetischen Rückschluß bilden.

## Claims

1. Apparatus for the coating of substrates which are disposed inside a vacuum chamber (1) on a substrate holder (25), said substrate holder being located at least partly in a coating region (24, 42, 43) on either side of which magnetron cathodes (7, 8) with magnet systems (12, 13) consisting of permanent magnets with outer poles (16, 17) and inner poles (14, 15) are disposed, their targets (18, 19) oriented towards the coating region (24, 42, 43), the polarity of the magnet systems (12, 13) of the magnetron cathodes (7, 8) being so selected that poles of opposite polarity lie opposite one another on either side of the coating region (24, 42, 43), characterised in that
a) at least one magnetic coil (21, 22) is disposed on each opposing side of the coating region (24, 42, 43), the opposing magnetic coils (21, 22) being connected to a power source (28) in such a manner that the fields of the magnetic coils (21, 22) complement each other to form a closed magnetic field, and in that
b) the polarity of the outer poles (16, 17) of the permanent magnet systems (12, 13) and of the magnetic coils (21, 22) is the same.

2. Apparatus according to claim 1, characterised in that at least one electrode (31, 32), which is isolated from the vacuum chamber (1) and can be applied to a voltage which is positive relative to earth, is disposed at least on either side of a virtual generated surface, which extends between the edges (29, 30) of the opposite target (18, 19).

3. Apparatus according to claim 2, characterised in that at least one further magnet system (34, 35, 36, 37) having outer (38, 39) and inner poles (40, 41) and which forms at least one closed magnetic tunnel on the inner face of the electrode (31, 32) facing the coating region (42) is disposed on the outer face of the electrode (31, 32) remote from the coating region (42), and in that the polarity of the outer poles (38, 39) of the magnet systems of the electrodes is opposite to the polarity of the outer poles (16, 17) of the magnet systems (12, 13) of the respectively adjacent magnetron cathodes (7, 8).

4. Apparatus according to claim 2, characterised in that, when magnetron cathodes (7, 8) with a rectangular target outline and two mutually opposite electrodes (31, 32) with a rectangular outline are used, the longitudinal edges have approximately the same length and are arranged parallel to one another.

5. Apparatus according to claim 4, characterised in that on the outer faces of the two opposite electrodes (31, 32), at least one elongate magnet system (34, 35, 30, 37) for generating at least one closed magnetic tunnel is disposed on each inner face of the respective electrode (31, 32).

6. Apparatus according to claim 4, characterised in that a plurality of magnetron cathodes (7, 8; 7a, 8a) are disposed opposite one another in pairs on each side of the vacuum chamber (1) and form a cathode group on each side of the vacuum chamber (1), and the distances between the longitudinal edges of directly adjacent targets (18/18a; 19/19a) are small in relation to the distances between the longitudinal edges of the same target, and in that a respective magnetic coil (21, 22) is disposed in the region of the edge of each cathode group.

7. Apparatus according to claim 1, characterised in that on each side of a virtual generated surface, which extends between the edges, each forming a rectangle, of the opposite target (18, 19), two further magnetron cathodes with targets are provided.

8. Apparatus according to claim 1, characterised in that, when a vacuum chamber (1) of a ferromagnetic material is used, the magnetic coils (21, 22) are close to the chamber walls, so that the chamber walls form a magnetic conclusion.

## Revendications

1. Dispositif pour le revêtement de substrats qui sont agencés à l'intérieur d'une chambre à vide (1) sur un porte-substrat (25), ledit porte-substrat étant situé au moins en partie dans une zone de revêtement (24, 42, 43) sur les deux côtés de laquelle sont agencées des cathodes magnétron (7, 8) avec des systèmes magnétiques (12, 13) comprenant des aimants permanents avec des pôles extérieurs (16, 17) et des pôles intérieurs (14, 15), les cibles (18, 19) desdites cathodes étant dirigées vers la zone de revêtement (24, 42, 43), la polarité des systèmes magnétiques (12, 13) des cathodes magnétron (7, 8) étant choisie de telle manière que des pôles à polarité contraire se font respectivement face sur les deux côtés de la zone de revêtement (24, 42, 43), caractérisé en ce que
a) au moins une bobine magnétique (21, 22) est agencée sur chacun des côtés opposés de la zone de revêtement (24, 42, 43), les bobines magnétiques opposées (21, 22) étant raccordées à une source de courant (28) de telle manière que les champs des bobines magnétiques (21, 22) se complètent en un champ magnétique fermé, et en ce que
b) la polarité des pôles extérieurs (16, 17) des systèmes à aimants permanents (12, 13) et des bobines magnétiques (21, 22) sont de même sens.

2. Dispositif selon la revendication 1, caractérisé en ce que sur les deux côtés au moins d'une surface enveloppe virtuelle qui s'étend entre les bordures (29, 30) des cibles opposées (18, 19) et qui entoure la zone de revêtement (24, 43), est agencée au moins une électrode (31, 32) qui est isolée de la chambre à vide (1) et qui peut être mise à une tension positive par rapport à la masse.

3. Dispositif selon la revendication 2, caractérisé en ce que sur le côté extérieur des électrodes (31, 32) détourné de la zone de revêtement (42) est agencé au moins un autre système magnétique (34, 35, 36, 37) avec des pôles extérieurs (38, 39) et des pôles intérieurs (40, 41), ledit système formant sur le côté intérieur des électrodes (31, 32) dirigé vers la zone de revêtement (42) au moins un tunnel magnétique fermé, et en ce que la polarité des pôles extérieurs (38, 39) des systèmes magnétiques des électrodes est choisie à l'opposé de la polarité des pôles extérieurs (16, 17) des systèmes magnétiques (12, 13) des cathodes magnétron (7, 8) voisines respectives.

4. Dispositif selon la revendication 2, caractérisé en ce que, lorsqu'on utilise des cathodes magnétron (7, 8) avec des cibles à contour rectangulaire et lorsqu'on utilise deux électrodes (31, 32) opposées l'une à l'autre avec des contours rectangulaires, les bordures longitudinales ont des longueurs à peu près égales et sont agencées parallèlement l'une à l'autre.

5. Dispositif selon la revendication 4, caractérisé en ce que sur les côtés extérieurs des deux électrodes opposées (31, 32) est agencé au moins un système magnétique allongé respectif (34, 35, 30, 37) pour produire au moins un tunnel magnétique fermé sur chacune des surfaces intérieures des électrodes respectives (31, 32).

6. Dispositif selon la revendication 4, caractérisé en ce que sur chaque côté de la chambre à vide (1) sont agencées plusieurs cathodes magnétron (7, 8; 7a, 8a) opposées les unes aux autres par paires, qui forment sur chaque côté de la chambre à vide (1) un groupe de cathodes, groupe dans lequel les distances des bordures longitudinales de cibles immédiatement voisines (18/1 8a; 19/19a) sont faibles par rapport aux distances des bordures longitudinales des mêmes cibles, et en ce que dans la région de la périphérie de chaque groupe de cathodes est agencée une bobine magnétique respective (21, 22).

7. Dispositif selon la revendication 1, caractérisé en ce que des deux côtés d'une surface enveloppe virtuelle qui s'étend entre les bordures des cibles opposées (18, 19), bordures qui forment chacune un rectangle, sont agencées deux autres cathodes magnétron avec des cibles.

8. Dispositif selon la revendication 1, caractérisé en ce que lorsqu'on utilise une chambre à vide (1) en matériau ferromagnétique, les bobines magnétiques (21, 22) sont rapprochées des parois (3a, 4a) de la chambre de telle manière que les parois de la chambre forment un circuit magnétique de retour.
